(19) Europäisches Patentamt
European Patent Office
Office européen des brevets

(11) EP 0 884 936 A1

(12) **EUROPEAN PATENT APPLICATION**
published in accordance with Art. 158(3) EPC

(43) Date of publication:
16.12.1998 Bulletin 1998/51

(51) Int. Cl.$^6$: **H05K 3/34**, H01L 21/60

(21) Application number: 97903633.2

(86) International application number:
PCT/JP97/00614

(22) Date of filing: 28.02.1997

(87) International publication number:
WO 97/32457 (04.09.1997 Gazette 1997/38)

(84) Designated Contracting States:
DE FR GB

(30) Priority: 28.02.1996 JP 40930/96

(71) Applicant: **Hitachi, Ltd.**
Chiyoda-ku, Tokyo 101 (JP)

(72) Inventors:
• **IJUIN, Masahito**
  **Fujisawa-shi, Kanagawa 251 (JP)**
• **NISHIKAWA, Toru,**
  **Hachimanyama Apartment 546**
  **Yokohama-shi, Kanagawa 244 (JP)**
• **SATO, Ryohei**
  **Yokohama-shi, Kanagawa 245 (JP)**

• **SHIRAI, Mitsugu**
  **Hadano-shi, aKanagawa 259-13 (JP)**
• **TANIGUCHI, Yuzo**
  **Kodaira-shi, Tokyo 187 (JP)**
• **INOUE, Kosuke**
  **Totsuka-ku, Yokohama-shi, Kanagawa 244 (JP)**

(74) Representative:
**Altenburg, Udo, Dipl.-Phys. et al**
**Patent- und Rechtsanwälte**
**Bardehle . Pagenberg . Dost . Altenburg .**
**Geissler . Isenbruck**
**Postfach 86 06 20**
**81633 München (DE)**

(54) **METHOD FOR MANUFACTURING ELECTRONIC CIRCUIT DEVICE**

(57)     A subject of the present invention is to provide a process for manufacturing an electronic circuit device by which solder can be applied at a low cost by fluxless bonding that enables uniform and simple application of solder and requires no cleaning step.

The present invention is a process for manufacturing an electronic circuit device by applying a solder material to electronic parts or electrodes on a printed circuit board; the process comprising the steps of removing an initial surface oxide film and an organic contaminant film from the surfaces of the solder material and electrode, covering the solder material and an area to which solder is to be applied which is comprised of the electrode, with a liquid capable of vaporizing up after the bonding is completed in the step of heat-melting the solder material, to thereby prevent reoxidation of the joining area surface, and heat-melting the solder material, to carry out solder bonding without using any flux.

FIG. 1
(a)
(b)
(c)
(d)
(e)

EP 0 884 936 A1

## Description

## TECHNICAL FIELD

This invention relates to a process for manufacturing an electronic circuit device by which solder can be applied to electrodes of electronic parts or circuit boards without using any flux. It also relates to a process for manufacturing an electronic circuit device by which electronic parts having solder balls can be bonded to circuit boards.

## BACKGROUND ART

With regard to the joining of electronic circuit devices, a mounting method making use of flip-chips and a bonding method such as BGA (ball grid array) making use of solder bumps attract notice as electronic instruments and electronic parts are made to have a smaller size, a higher density and a higher performance. Such methods are energetically developed. The bonding method making use of solder bumps is characteristic of an excellent electrical performance exhibited because of wiring length that can be made shorter than that of leads or the like and also an ease of mounting because of bumps arranged in grids so that terminal pitches can be made smaller than QFPs.

In this bonding method, solder bumps must be previously applied to electrodes provided on the side of the board or substrate and must be surely applied to the intended electrodes without any defects such as uneven solder quantity and bridges.

Bumps are applied by, e.g., (1) a method in which solder films are formed by plating or vacuum evaporation, (2) a method in which a solder paste is printed and (3) a method in which solder balls are laid out.

In the method (1), solder films are formed at bonding areas by plating or vacuum evaporation, and a flux is coated thereon, which is thereafter heat-melted to provide bumps.

In the method (2), as reported in, e.g., 1st Symposium "Microjoining and Assembly Technology in Electronics '95", Draft Collection, pp.187-192, a solder paste used in conventional surface packaging is printed on electrodes, followed by heat-melting.

In the method (3), as disclosed in, e.g., U.S. Patent No. 5,284,287, solder balls are laid out on an aligning jig having holes or concaves formed correspondingly to the electrodes, and are aligned with the electordes, followed by heat-melting to provide bumps.

Methods making use of fluxes are commonly in wide use not only in the joining of electronic circuit devices but also when solder is applied to joining areas. Each of the above methods uses fluxes. The joining making use of solder is brought about by metallic bond between the solder and a matrix at areas to be joined (joining-area matrix). Since the surfaces of the solder material and joining-area matrix are covered with oxide films or organic contaminant films, they are not joined if the solder material is heat-melted as they are. Accordingly, the flux is used, thus the surface oxide films and organic contaminant films are chemically removed and also the flux covers the joining areas, so that a clean surface condition can be maintained, reoxidation can be prevented and the both can be well joined without being affected by surrounding conditions.

In above three types of methods for providing solder bumps, the method (1), in which solder films are formed by plating or vacuum evaporation, has problems that it requires equipment cost for the plating or vacuum evaporation compared with other methods and also makes it difficult to control layer thickness and composition to form uniform solder bumps. The method (2), in which a solder paste is printed, has a problem that when the solder paste is not completely transferred when printed and remains on a metal mask to make uneven or insufficient the quantity of the solder applied. To solve such a problem of insufficient transfer, a method is proposed in which the printed solder paste is heat-melted while keeping the mask brought into close contact with the substrate, which, however, has a problem that the solder is not transferred if the substrate warps when heated. The method (3), in which solder balls are laid out an aligning jig having holes or concaves formed correspondingly to the electrodes and are mounted on the electrodes followed by heat-melting, can achieve less unevenness in the quantity of solder to be applied than the methods (1) and (2), and hence can achieve less unevenness in the height of bumps.

However, any of the above methods make use of the flux. Accordingly, they require a cleaning step because flux residues are left after the heat-melting. Hitherto, the flux residues have been removed by cleaning with organic solvents such as chlorofluorocarbons and trichloroethane, having an excellent cleanability. These cleaning agents, however, have caused an environmental problem of the ozone-shield destruction. The voids that are produced when the flux is taken into bonding areas have also come into question. In particular, since spherical bodies, like the solder bumps, are arranged in grids, it is difficult to carry out cleaning compared with solder bonding of conventional chip elements and QFPs, so that the flux residues cannot be completely removed to bring about a possibility of causing corrosion and migration.

In the method (2), if the solder is not completely transferred and remains on the metal mask, the surface must be cleaned every time the solder paste is printed. In the method (3), too, if the flux adheres to the aligning jig at the time of mounting, there is a problem that the solder balls are not transferred at the time of next mounting because of a tackiness of the flux. Thus, like the method (2), in which the solder is applied using solder paste, the aligning jig must also be cleaned, and this is a problem in respect of work efficiency and productivity.

## DISCLOSURE OF THE INVENTION

Accordingly, a first object of the present invention is to provide a process for manufacturing an electronic circuit device by which solder can be applied at a low cost by fluxless bonding that enables easy and simple application of uniform solder and requires no cleaning step.

The above first object can be achieved by a process for manufacturing an electronic circuit device by applying a solder material to an electrode the electronic circuit device has; the process comprising the steps of;

removing an initial surface oxide film and/or an organic contaminant film from the surface(s) of the solder material and/or electrode;
covering the solder material and/or the electrode with a liquid; and
heat-melting the solder material;

to carry out solder bonding without using any flux.

The object can also be achieved by a process for manufacturing an electronic circuit device by applying a solder material to an electrode the electronic circuit device has; the process comprising the steps of;

printing or coating on the electrode a paste comprising a mixture of a liquid and a solder powder; the liquid having a reducing action to remove an initial surface oxide film and/or an organic contaminant film from the surface(s) of the solder material and/or electrode; and
heat-melting the paste;

to carry out solder bonding without using any flux.

The object can still also be achieved by a process comprising the steps of;

mounting a solder material on an electrode with registration; the solder material being a material on which an initial surface oxide film has been thinly formed, and the electrode being an electrode on the surface of which an oxidation preventive film has been formed;
covering the solder material and/or the electrode with a liquid; and
heat-melting the solder material;

to carry out solder bonding without using any flux.

The object can still also be achieved by;

mounting an anisotropic conductive film on an electrode with registration; the film being a film on which solder has been formed correspondingly to an electrode to which the solder is to be applied, and the electrode being coated with a liquid; and
heat-melting the solder material.

In this instance, the liquid may preferably be a liquid capable of vaporizing up after the bonding is completed in the heat-melting step, because the solder material can thereby be well wetly spread.

The liquid may also preferably be a liquid having a reducing action, because the oxide films and organic contaminant films can thereby be removed from the electrode and solder material surfaces.

The liquid may also preferably be a liquid having a surface tension or viscosity high enough for the solder material to be provisionally fastened to the electrode.

A resist may preferably be formed in a thickness which is large at the area surrounding the electrode, because the solder material can thereby be prevented from coming off the surface of the electrode after the solder material is mounted thereon and until the bonding is completed in the heat-melting step.

For example, in the present invention, solder balls are laid out on an aligning jig having holes or concaves formed correspondingly to the electrodes to which the solder is to be applied, and thereafter are mounted on the electrodes with registration after a liquid is coated on the surfaces of electrodes or on the surfaces of solder balls laid out; the liquid being capable of vaporizing up after the bonding is completed in the heat-melting step. As the result, like the instance where the flux is used, this liquid isolates the solder balls and electrodes from the surrounding environment at the time of heating. Hence, even in a surrounding environment of a high oxygen concentration as in the atmosphere, the solder material and electrode surfaces can be prevented from being re-oxidized. Thus, the solder is wetly spread over the electrode surfaces at the time of solder melting, and the solder is applied onto the electrodes. Moreover, when the liquid having a reducing action is used as the above liquid, the initial oxide films can be removed from the electrode surfaces, so that the solder can be readily applied to the electrode surfaces. Also, since this liquid is vaporized off at the time of heat-melting, any residues as in the case of the flux by no means remain to make it unnecessary to clean the joint areas and jig after the solder has been applied. Incidentally, in order to prevent the initial surface oxide films and organic contaminant films, the electrode surfaces may be protected with films of solder, Sn, Au, Ni or Pd. This enables the solder to be more surely supplied. The initial oxide films on the solder material and electrode surfaces may also be removed by physical means such as sputter etching or plasma etching, mechanical means such as polishing, or chemical means such as pickling, and thereafter the solder material may be heat-melted in the presence of the above liquid. Thus, the solder can be applied likewise even when thicker oxide films are formed on the solder material and electrode surfaces.

Meanwhile, after the initial oxide films are physically removed and the solder balls are laid out on the jig and mounted on the electrodes, the solder balls may be heat-melted in a non-oxidizing atmosphere. This enables prevention of the reoxidation and makes it unnecessary to carry out not only the cleaning but also the coating of the liquid.

The problems previously discussed may occur also when electronic parts having solder balls are bonded to circuit boards.

Accordingly, a second object of the present invention is to provide a process for manufacturing an electronic circuit device by bonding electronic parts to circuit boards in a high reliability by fluxless bonding.

The above second object can be achieved by a process for manufacturing an electronic circuit device by bonding an electronic part having solder balls to a circuit board; the process comprising the steps of;

removing an initial surface oxide film and/or an organic contaminant film from the solder material and/or the circuit board at its area to which solder is to be applied;
covering with a liquid the solder material and/or the circuit board at its area to which solder is to be applied; and
heat-melting the solder material;

to carry out solder bonding without using any flux.

The object can also be achieved by a process comprising the steps of;

mounting a solder material with registration, on a circuit board at its area to which solder is to be applied; the solder material being a material an electronic part has and on which an initial surface oxide film has been thinly formed, and the area to which solder is to be applied being an area on the surface of which an oxidation preventive film has been formed;
covering with a liquid the solder material and/or the area to which solder is to be applied; and
heat-melting the solder material;

to carry out solder bonding without using any flux.

## BRIEF DESCRIPTION OF THE INVENTION

Fig. 1 is a cross-sectional view showing steps used in the process for manufacturing an electronic circuit device, which illustrates the principle, and also a first example, of the present invention.

Fig. 2 is a cross-sectional view showing steps used in the process for manufacturing an electronic circuit device, which similarly illustrates a second example of the present invention.

Fig. 3 is a cross-sectional view showing steps used in the process for manufacturing an electronic circuit device, which similarly illustrates a third example of the present invention.

Fig. 4 is a cross-sectional view showing steps used in the process for manufacturing an electronic circuit device, which similarly illustrates a fourth example of the present invention.

Fig. 5 is a cross-sectional view showing steps used in the process for manufacturing an electronic circuit device, which similarly illustrates a fifth example of the present invention.

Fig. 6 is a cross-sectional view showing steps used in the process for manufacturing an electronic circuit device, which similarly illustrates a sixth example of the present invention.

Fig. 7 is a cross-sectional view showing steps used in the process for manufacturing an electronic circuit device, which similarly illustrates a seventh example of the present invention.

Fig. 8 is a cross-sectional view showing steps used in the process for manufacturing an electronic circuit device, which similarly illustrates an eighth example of the present invention.

Fig. 9 is a cross-sectional view showing steps used in the process for manufacturing an electronic circuit device, which similarly illustrates a ninth example of the present invention in which the anisotropic conductive film is used.

Fig. 10 is a table showing the evaluation results of bonding performance attributable to various liquids.

Fig. 11 is a diagram showing the step of bonding an electronic part to a circuit board.

Fig. 12 is a graphic representation showing the results of analysis of residues.

Fig. 13 is a table showing the evaluation results of bonding performance attributable to various liquids.

## BEST MODES FOR WORKING THE INVENTION

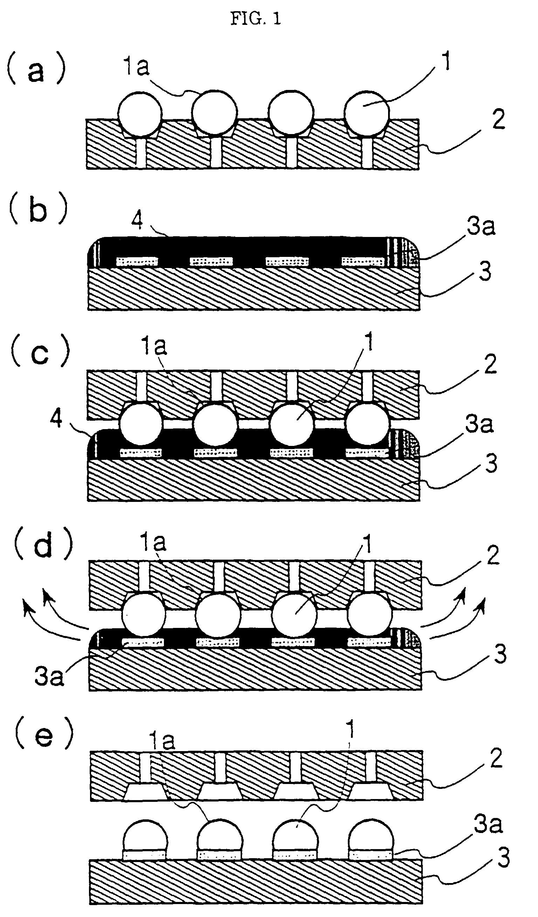

The principle of the present invention will be specifically described making reference to the flow chart in Fig. 1 as a typical example. As shown in Fig. 1 (a), on an aligning jig 2 in which holes or concaves have been formed so that solder balls 1 to be applied can be fitted thereto, correspondingly to the electrodes to which the solder is to be applied, the solder balls 1 are laid out by vacuum suction or the like while vibrating the aligning jig 2. Next, as shown in Fig. 1 (b), on an electronic part or circuit board 3 to which the solder is to be applied, a liquid 4 capable of vaporizing up after the bonding is completed in the heat-melting step is coated by, e.g., spraying, squeezing, spraying or using a dispenser to such an extent that the surfaces of electrodes 3a and the solder balls 1 at their portions coming into contact with the electrodes 3a at the time of heat-melting are covered. Then, as shown in Fig. 1 (c), the aligning jig 2 to which the solder balls 1 have been fitted is turned upside down while the solder balls are held by vacuum suction, and the solder balls 1 are mounted on the electrodes 3a after the former's registration to the latter.

Thereafter, heating is started, so that the liquid 4 comes to have the melting temperature of the solder while gradually vaporizing as shown in Fig. 1 (d). At this stage, surface oxide films are broken as a result of volumetric expansion caused by melting of the solder balls. Meanwhile, the surfaces of electrodes 3a are still covered with the liquid 4, and hence they are isolated from oxygen in the surrounding air not to undergo reoxidation. Accordingly, fresh surfaces of molten solder balls 1 come into contact with the surfaces of electrodes 3a, and the solder is wetly spread over the electrode surfaces. Thereafter, as shown in Fig. 1 (e), the vacuum suction is released before the solder solidifies, and the aligning jig 2 is put apart from the solder balls 1. Thus, an electronic circuit device can be obtained in which uniformly good and spherical solder balls are formed without any deformation of solder balls which may be caused by the jig 2.

An alcohol type liquid may also be used as a liquid 4 having a boiling point that is not lower than the melting point of the solder and not higher than a peak temperature at the time of heat-melting. Such a liquid also has the action to reduce the initial surface oxide films of the solder balls 1 and electrodes 3a, and hence the surface oxide films can be made thinner, so that the surface oxide films can be readily broken at the time of melting of the solder and the solder can be readily wetly spread over the electrodes 3a.

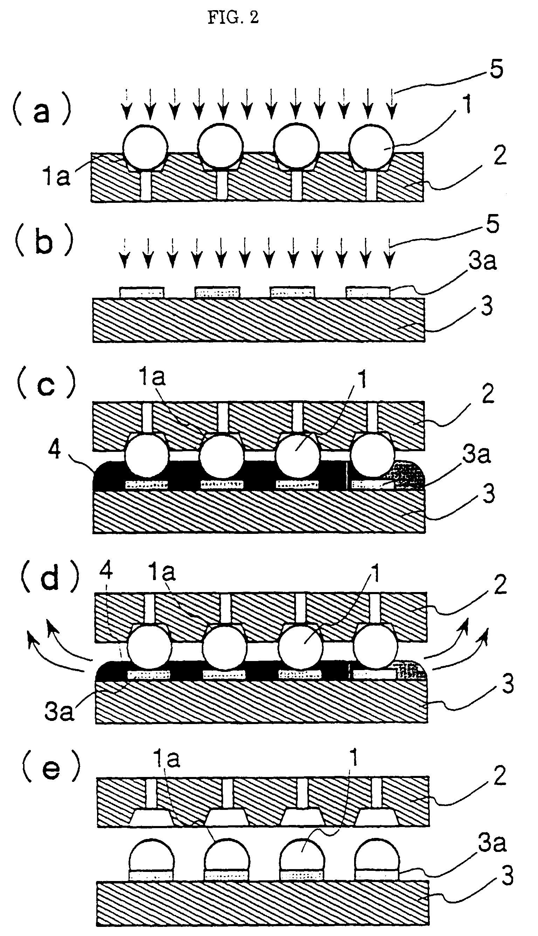

As another example, as shown in Fig. 2 (a) and (b), after the solder balls 1 are fitted to the aligning jig 2, the surfaces of solder balls 1 and the surfaces of electrodes 3a are subjected to sputter etching or plasma beam or laser beam treatment to remove the initial surface oxide films on the surfaces. Thereafter, as shown in Fig. 2 (c) to (e), the procedure as shown in Fig. 1 is repeated to coat the liquid to prevent reoxidation, followed by registration, mounting and heat-melting. Thus, it becomes possible to establish a process of well applying the solder.

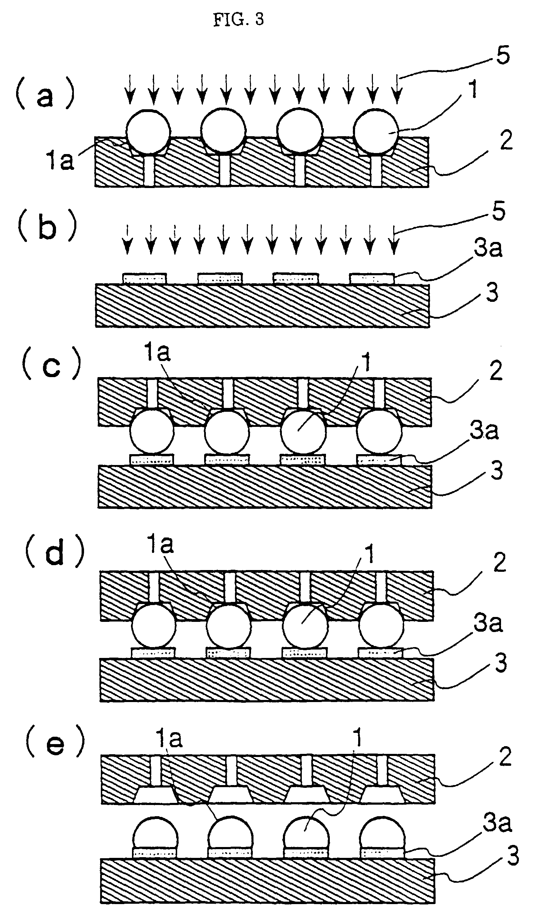

As also shown in Fig. 3 (a) and (b), after the initial surface oxide films are removed from the surfaces of solder balls 1 and the surfaces of electrodes 3a, the solder balls are registered to and mounted on the electrodes without applying the liquid, as shown in Fig. 3 (c). Then, as shown in Fig. 3 (d), the solder is heat-melted in a non-oxidizing atmosphere, e.g., in an atmosphere of helium, argon, nitrogen, hydrogen or a mixed gas of any of these. Thus, the surfaces of the solder balls 1 and electrodes 3a can be prevented from reoxidation, and hence, as shown in Fig. 3 (e), the solder can be applied without coating any liquid.

Examples of the present invention will be described below in detail with reference to the drawings.

EXAMPLE 1

Fig. 1 cross-sectionally illustrates a process of applying solder balls to the electrodes on a printed circuit board, using the process for manufacturing an electronic circuit device according to the present invention. The process will be detailed below in the order of steps. First, as shown in Fig. 1 (a), on the aligning jig 2 made of, e.g., glass and in which holes have been formed correspondingly to the electrodes 3a to which the solder is to be applied, solder balls 1 composed of, e.g., an eutectic of Sn and Pb (melting point: 183°C) are laid out by vacuum suction or the like while vibrating the aligning jig. Meanwhile, as shown in Fig. 1 (b), on the electrodes 3a of a printed circuit board 3 to which the solder is to be applied, a liquid 4 capable of vaporizing in the heat-melting step, e.g., ethylene glycol (boiling point: 198°C) is coated by spraying or the like in a stated quantity, i.e., in such a quantity that it remains in a quantity necessary only for covering the solder ball and electrode surfaces, when the solder melts. Next, as shown in Fig. 1 (c), the aligning jig 2 is turned upside down while the solder balls 1 are held thereon by vacuum suction, and the solder balls 1 are mounted on the electrodes 3a with registration of the solder balls 1 to their corresponding electrodes 3a.

Thereafter, as shown in Fig. 1 (d), heat-melting is carried out at temperatures up to about 220°C. Here, an alcohol type liquid such as ethylene glycol is used as the liquid 4. Since it has a reducing action, the initial surface oxide films 1a on the solder ball surfaces are removed. Also, since the surfaces of electrodes 3a are covered with the liquid 4 until the solder balls 1 melt and the bonding is completed, they undergo no reoxidation. Such removal of initial surface oxide films and prevention of reoxidation enable the solder to be wetly spread on over the electrode surfaces when the solder balls 1 melt. Then, as shown in Fig. 1 (e), the aligning jig 2 is detached from the solder balls 1. Thus, an electronic circuit device can be obtained in which the solder has been fluxlessly-applied to the electrodes 3a on the printed circuit board 3. Accordingly, it becomes unnecessary to provide any cleaning steps of removing flux residues and of removing fluxes adhering to the aligning jig 2, which are required in the conventional solder application making use of fluxes. Incidentally, the aligning jig may preferably be detached in the course of melting of the solder balls 1 so that the solder balls 1 do not deform.

EXAMPLE 2

Fig. 2 cross-sectionally illustrates a process of applying solder, which additionally has, before the registration and mounting of solder balls, the step of removing the initial surface oxide films and organic contaminant films from the surfaces of solder balls 1 and the surfaces of electrodes 3a formed on the printed circuit board 3.

As shown in Fig. 2 (a), solder balls 1 composed of, e.g., Au20 wt.% Sn (melting point: 280°C), which is an eutectic solder of Au and Sn, are laid out on the aligning jig 2 correspondingly to the electrodes 3a, in the same manner as that shown in Fig. 1 (a), and thereafter the initial surface oxide films on the solder ball surfaces are removed by, e.g., Ar sputter etching. Similarly, as shown in Fig. 2 (b), the surfaces of electrodes 3a on the printed circuit board 3 are subjected to Ar sputter etching to remove initial surface oxide films and organic contaminant films therefrom.

Thereafter, as shown in Fig. 2 (c), a liquid 4 capable of vaporizing in the heat-melting step, e.g., tetraethylene glycol (boiling point: 314°C) is coated on the printed circuit board 3, where the aligning jig 2 to which the solder balls 1 have been fitted as shown in Fig. 2 (a), is turned upside down, and the solder balls are mounted on their corresponding electrodes 3a with former's registration to the latter. Thereafter, as shown in Fig. 2 (d), heat-melting is carried out at temperatures up to about 310°C. Here, the initial surface oxide films have been removed before the solder balls are mounted. Hence, even though the liquid has no reducing action, very thin oxide films on the solder balls break as a result of volumetric expansion of solder when the solder balls melt, thus the solder is wetly spread over the surfaces of electrodes 3a, so that, as shown in Fig. 2 (e), the solder is fluxlessly-applied to the electrodes 3a.

EXAMPLE 3

Fig. 3 cross-sectionally illustrates a process of applying solder without using the above liquid after the step of removing the surface oxide films in the same manner as the process shown in Fig. 2.

First, as shown in Fig. 3 (a), solder balls 1 composed of, e.g., Sn3.5 wt.% Ag (melting point: 223°C), which is an eutectic solder of Sn and Ag, are laid out on the aligning jig 2 correspondingly to the electrodes 3a, in the same manner as that shown in Fig. 2 (a), and thereafter the initial surface oxide films on the solder ball surfaces are removed by, e.g., plasma cleaning. Similarly, as shown in Fig. 3 (b),the surfaces of electrodes 3a on the printed circuit board 3 are subjected to plasma cleaning to remove initial surface oxide films and organic contaminant films therefrom.

Then, as shown in Fig. 3 (c), the aligning jig 2 to which the solder balls 1 have been fitted as shown in Fig. 3 (a), is turned upside down, and the solder balls are mounted on their corresponding electrodes 3a with former's registration to the latter. Thereafter, as shown in Fig. 3 (d), heat-melting is carried out in a non-oxidizing atmosphere, e.g., in an atmosphere of N2 (oxygen concentration: about 10 ppm). The heating is carried out at a peak temperature of, e.g., 250°C. Thus, the surface initial surface oxide films are removed and the reoxidation is prevented in the non-oxidizing atmosphere. Accordingly, thin oxide films of few nm or so on the solder balls break when the solder balls melt, and the solder is wetly spread over the surfaces of electrodes 3a, so that, as shown in Fig. 3, Step (e), the solder is applied to the electrodes 3a on the printed circuit board 3 without using any flux.

EXAMPLE 4

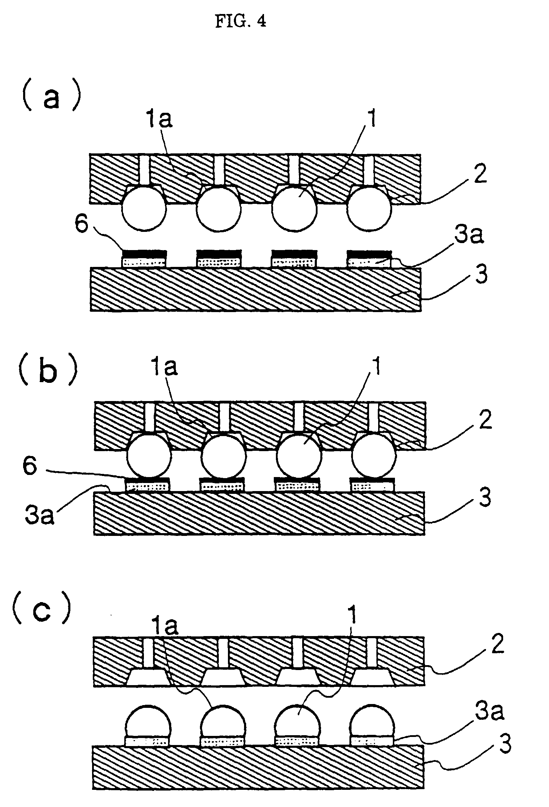

Fig. 4 cross-sectionally illustrates a process of applying solder in the present invention, without using the liquid used in Examples shown in Figs. 1 and 2 and the step of removing the surface oxide films in Examples shown in Figs. 2 and 3.

First, as shown in Fig. 4 (a), solder balls 1 composed of, e.g., Sn3.5 wt.% Ag and whose initial surface oxide films are retained in a thickness of about 5 nm or less are laid out on the aligning jig 2 correspondingly to the electrodes 3a, in the same manner as that shown in Fig. 1 (a). Meanwhile, the surfaces of electrodes 3a on the printed circuit board 3 are plated with Sn or the like in a thickness of, e.g., about 1 to 20 μ m to form electrode protective films 6. Then, as shown in Fig. 4 (b), the aligning jig 2 to which the solder balls 1 have been fitted is turned upside down, and the solder balls are mounted on their corresponding electrodes 3a with former's registration to the latter. Then, heat-melting is carried out at temperatures up to about 250°C in a non-oxidizing atmosphere, e.g., in an atmosphere of He (oxygen concentration: 10 ppm). Since originally the oxide films on the solder ball surfaces have been controlled to be few nm thick or so and the reoxidation has been prevented in the non-oxidizing atmosphere, the solder of the solder balls 1 having melted, whose thin oxide films have broken as a result of volumetric expansion, is wetly spread on over the surfaces of electrodes 3a, so that, as shown in Fig. 4 (c), the solder is fluxlessly-applied.

EXAMPLE 5

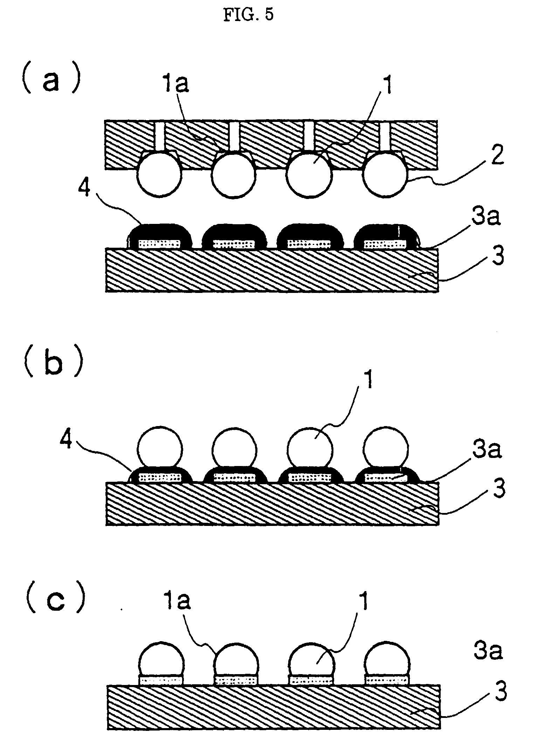

Fig. 5 cross-sectionally illustrates a process of applying solder by coating for each electrode a liquid 4 capable of vaporizing up after the bonding is completed in the heat-melting step.

As shown in Fig. 5 (a), solder balls 1 composed of, e.g., Au20 wt.% Sn are laid out on the aligning jig 2 correspondingly to the electrodes 3a, in the same manner as that shown in Fig. 1 (a). Thereafter, the aligning jig is turned upside down while keeping the vacuum suction. Also, the liquid 4 capable of vaporizing up after the bonding is completed in the heat-melting step is coated on the electrodes 3a formed on the printed circuit board 3, which is coated for each electrode 3a by, e.g., metal-mask printing. Then, the solder balls 1 are mounted on their corresponding electrodes 3a with former's registration to the latter. Thereafter, the vacuum suction is released to detach the aligning jig 2. The solder balls 1 thus mounted are, as shown in Fig. 5 (b),provisionally fastened with the liquid 4 coated for each electrode 3a, without requiring their holding with the aligning jig 2. Then, heat-melting is carried out, so that, as shown in Fig. 5 (c), the solder is fluxlessly-applied onto the electrodes 3a.

## EXAMPLE 6

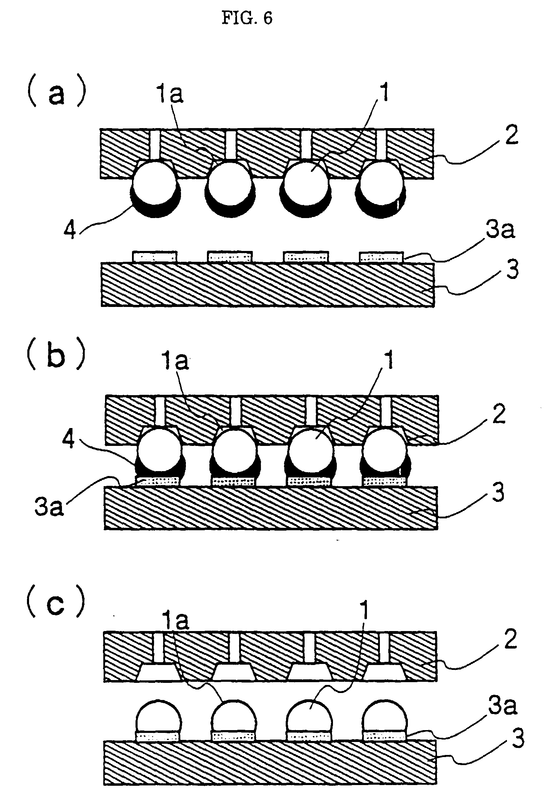

Fig. 6 cross-sectionally illustrates a process in which a liquid 4 capable of vaporizing up after the bonding is completed in the heat-melting step is applied on the side of solder balls 1.

First, solder balls 1 composed of, e.g., Sn3.5 wt.% are laid out on the aligning jig 2 correspondingly to the electrodes 3a, in the same manner as that shown in Fig. 1 (a). Thereafter, the aligning jig is turned upside down while keeping the vacuum suction. Then, the aligning jig 2 to which the solder balls 1 have been fitted is immersed in the liquid 4 capable of vaporizing up after the bonding is completed in the heat-melting step, thus the liquid 4 is coated on the solder balls 1 as shown in Fig. 6 (a).

Next, as shown in Fig. 6 (b), the solder balls 1 are mounted on their corresponding electrodes 3a with former's registration to the latter, so that the solder balls and electrode surfaces are covered with the liquid 4. This prevents the reoxidation, where the heat-melting is carried out, so that, as shown in Fig. 6 (c), the solder balls 1 is fluxlessly-applied to the electrodes 3a.

## EXAMPLE 7

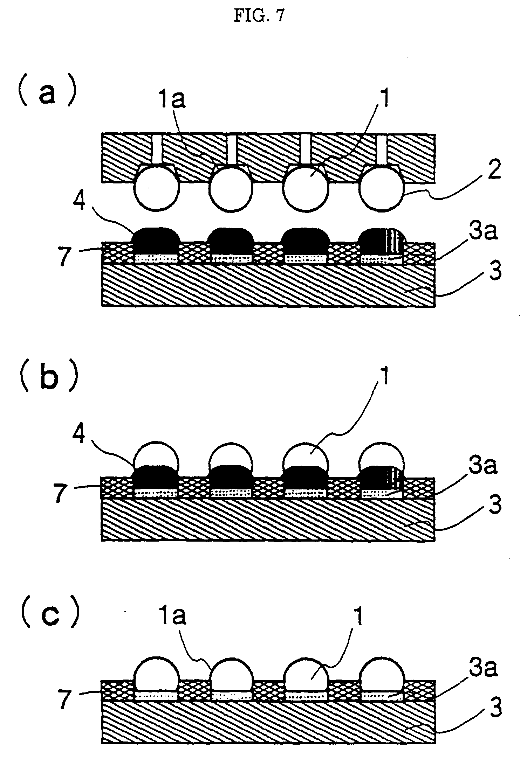

Fig. 7 cross-sectionally illustrates a process of applying solder to electrodes in the present invention without holding the solder balls by means of the aligning jig or provisionally fastening them with utilization of surface tension of the liquid.

First, as shown in Fig. 7 (a), solder balls 1 composed of, e.g., an eutectic of Sn and Pb (melting point: 183°C) are laid out on the aligning jig 2 in the same manner as that shown in Fig. 4 (a), which is then turned upside down. Meanwhile, on a printed circuit board 3, the board surface other than electrodes 3a is coated with a resist 7 in order to protect the wiring from oxidation or corrosion. The resist is formed in a thickness necessary only for making the solder balls 1 not come off the electrodes 3a because of vibration or the like when mounted thereon. Then, as shown in Fig. 7 (a), on the electrodes 3a of a printed circuit board 3 to which the solder is to be applied, a liquid 4 capable of vaporizing in the heat-melting step, e.g., benzyl alcohol (boiling point: 206°C) is coated using a dispenser or the like in such a quantity that it remains in a quantity necessary only for covering the solder ball and electrode surfaces, when the solder melts. Then, the aligning jig 2 to which the solder bails 1 have been fitted is turned upside down, the solder balls are mounted on their corresponding electrodes 3a with former's registration to the latter, and the aligning jig 2 is put apart from the solder balls 1.

Thus, as shown in Fig. 7 (b), the solder balls can be prevented from coming off without holding them by means of the aligning jig or provisionally fastening them with utilization of surface tension of the liquid 4. Then, heat-melting is carried out at temperatures up to about 220°C. Thus, as shown in Fig. 7 (c), on account of the action to remove the initial surface oxide films that is attributable to the reducing action of benzyl alcohol and on account of the reoxidation preventive effect, the solder is wetly spread over the surfaces of electrodes 3a and also the liquid 4 vaporizes, so that the solder is fluxlessly-applied.

## EXAMPLE 8

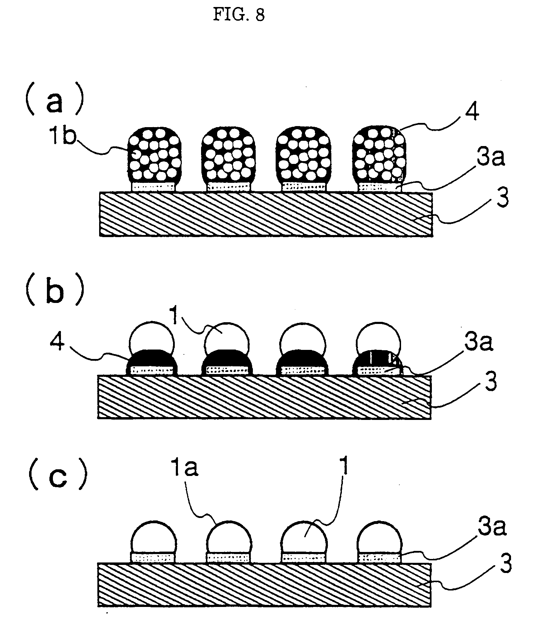

Fig. 8 cross-sectionally illustrates a process of applying solder in the present invention which is applied in the form of a paste prepared by mixing a solder powder with the liquid capable of vaporizing in the heat-melting step.

A solder powder composed of, e.g., Sn3.5 wt.% Ag and a liquid capable of vaporizing in the heat-melting step and having a great viscosity are mixed to form a paste. Using a mask with a pattern corresponding to the electrodes to which the solder is to be applied, the paste thus prepared is printed as shown in Fig. 8 (a), in the same manner as conventional solder pastes to apply it only in a necessary quantity.

Then, as shown in Fig. 8 (b), heat-melting is carried out at temperatures up to about 250°C. Upon melt of the solder paste, the solder powder aggregates into balls, where the solder is wetly spread on over the electrodes 3a and also the liquid completely vaporises before the heat-melting step is completed, so so that, as shown in Fig. 8 (c), the solder is fluxlessly-applied.

## EXAMPLE 9

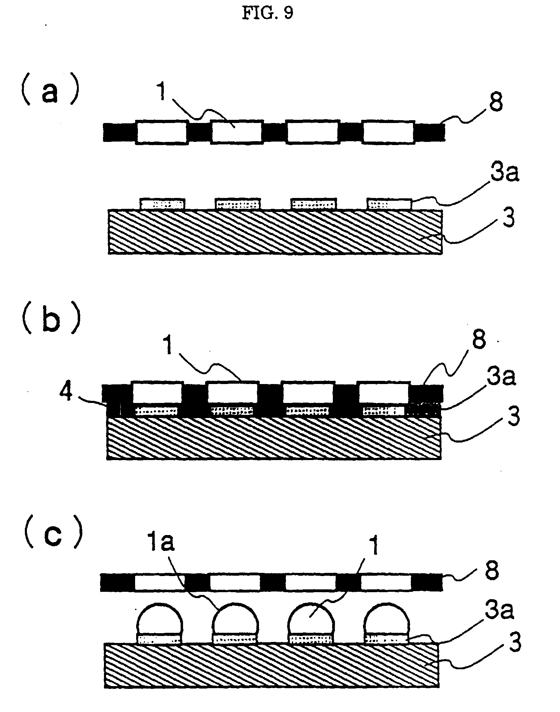

Fig. 9 cross-sectionally illustrates a process of applying solder in the present invention by using in combination the liquid capable of vaporizing in the heat-melting step and an anisotropic conductive film.

First, as shown in Fig. 9 (a), an anisotropic conductive film 8 in which solder composed of, e.g., an eutectic of Sn and Pb (melting point: 183°C) has been formed only in a necessary quantity correspondingly to the pitch of electrodes 3a to which the solder is to be applied is, as shown in Fig. 9 (b), brought into closed contact with the surface of a printed circuit board 3 on which a liquid 4 capable of vaporizing in the heat-melting step, e.g., trimethylene glycol (boiling point: 214°C) has been coated; the both being done with registration of the former's pitch to the latter's electrodes.

Then, heat-melting is carried out at temperatures up to about 220°C. Thus, on account of the action to remove the initial surface oxide films that is attributable to the reducing action of trimethylene glycol and on account of the reoxidation preventive effect, the molten solder is wetly spread over the electrodes 3a, where the film 8 is detached, so that, as shown in Fig. 9 (c), the solder is applied onto the circuit board 3. Incidentally, in order to prevent deformation of the solder applied, the diameter of each solder circle formed in the anisotropic conductive film 8 may preferably be kept larger than the diameter of each solder ball 1 finally formed on the electrode, to such an extent that the solder adjacent to each other may not become bridged.

EXAMPLE 10

Conditions necessary for the liquid having been described above will be briefly described.

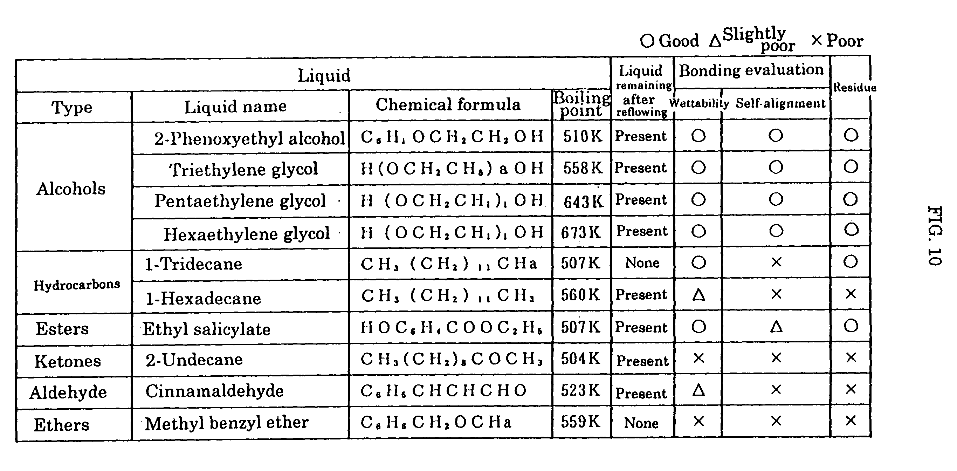

Fig. 10 shows the results of evaluation made on bonding performance (wettability, self-alignment, and fromation of residues) attributable to alcohols, hydrocarbons, esters, ketones, aldehydes or ethers which are used as the liquid for provisional fastening in the present invention.

First, with regard to the wettability, alcohols, hydrocarbons and esters show good results. The wettability refers to the degree of how well the solder is wetly spread over the whole electrodes. Accordingly, any of these liquids contributes to good bonding when the solder balls are applied to substrates or LSIs.

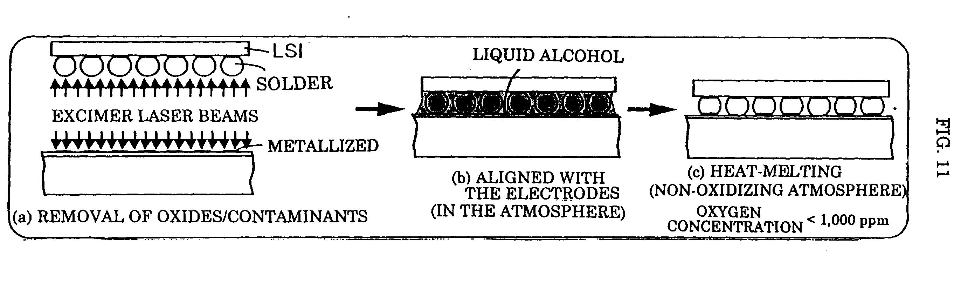

After the solder balls are applied to LSIs or the like, the LSIs must be flip-chip bonded to a substrate on the counterpart side. This bonding may also preferably be processed by fluxless bonding. For example, as shown in Fig. 11, an LSI having solder balls, and/or an oxide film and/or a contaminant layer on the surface of a metallized substrate, is/are removed using excimer laser beams or the like, and thereafter the space between the LSI and the substrate is filled with the liquid alcohol, where the heat-melting may preferably be carried out in a non-oxidizing atmosphere. In this instance, the liquid used is required to have a good bonding performance (self-alignment), and the alcohols can satisfy this point. Incidentally, the self-alignment refers to the effect of self-correcting any positional deviation by the aid of surface tension produced when the solder melts, even if the positional deviation occurs when solder balls are arranged with registration to carry out bonding with solder balls or apply solder through solder balls.

Accordingly, the alcohols are the best for the liquid that is good for both applying balls to substrates or LSIs and bonding LSIs to substrates (or bonding substrates to substrates).

When selected from among the alcohols, which include various types of liquid, it is necessary to select the melting point of solder and the boiling point of alcohol. Basically, it is necessary to select an alcohol such that the liquid can be present around the solder balls and electrodes at a temperature not lower than the melting point of solder. This is because only any slight deposition of residues of the liquid, which may occur on the electrodes before the solder is wetly spread, prohibits the solder from being wetly spread.

In this regard, liquids having boiling points higher than 2-phenoxyethyl alcohol are preferred, which are shown in Fig. 10.

Next, investigation will be made on residues. In Fig.

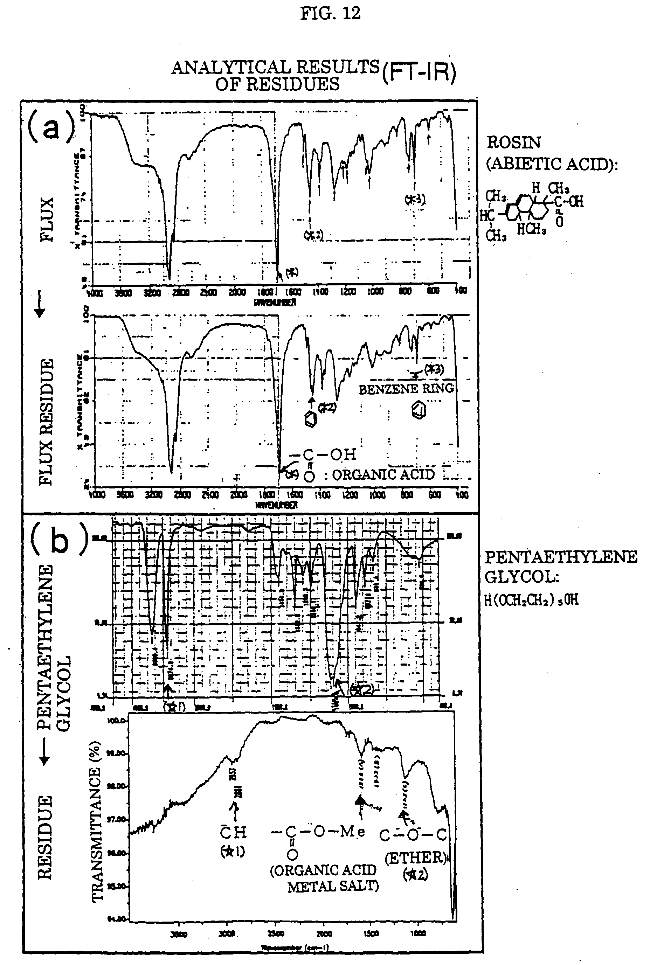

10, those marked with a circle indicate that the liquid causes very less residues and has no problem in practical use. However, as shown in Fig. 12 (b) by FT-IR analysis, an organic metal salt which is a reaction product of an organic acid with a metal is detected, though very slightly, when an alcohol type liquid is used. A migration test made in an environment of high temperature and high humidity has ascertained that this product is in a very small quantity and has no electrical or chemical problem.

Fig. 12 (a) shows the results of TF-IR analysis of a flux and flux residues in an instance where a conventional flux is used. As shown in Fig. 12 (a), peaks assigned to an organic acid made by abietic acids formed as a result of modification of rosin in the flux and peaks assigned to benzene rings are detected. These organic acids and benzene rings have a high possibility of causing migration. Moreover, in the case of fine bonding as in flip-chip bonding, they have so much a higher possibility of causing the migration that cleaning is required. However, since it is very difficult to clean fine areas, the fluxless bonding of the present invention can be effective.

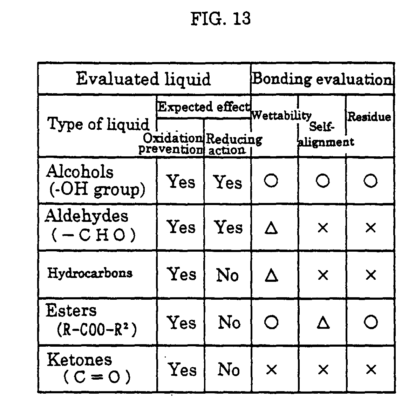

A summary of the results of investigation shown in Fig. 10 is shown in Fig. 13. As can be seen also from Fig. 13, the alcohols show good results on all the wettability, the self-alignment and the residues. This is because, when the alcohol type liquid is heated, the reaction is presumed to proceed as follows for Sn type solders for example:

(1) As shown by Formula (1), an alcohol, which has an -OH group, undergoes oxidation as a result of the reaction of the -OH group with a surface oxide, and is converted into an aldehyde (-CHO) with a lower boiling point. A part thereof further reacts with the oxide and is converted into an organic acid as shown by Formula (2). This organic acid has a higher boiling point than the original alcohol, and hence remains as a residue if it stands as it is. However, as shown by Formula (3), as a result of decarboxylation to have a lower boiling point, it vaporizes and does not form any residue. Also, as shown by Formula (4), it may form a metal salt in some cases, which slightly remains as a residue.

$$R\text{-}OH + SnO \rightarrow R'\text{-}CHO + Sn \downarrow + H_2O \uparrow \qquad (1)$$

$$R'\text{-}CHO + SnO \rightarrow R'\text{-}COOH \downarrow + Sn \downarrow \qquad (2)$$

$$R'\text{-}COOH + SnO \rightarrow R'\text{-}H \uparrow + CO_2 \uparrow \qquad (3)$$

$$R'\text{-}COOH + SnO \rightarrow (R'COO)_2Sn \downarrow + H_2O \uparrow \qquad (4)$$

As stated above, the use of the alcohol type liquids as shown in the drawing makes it possible to carry out good solder application and solder bonding without requiring any flux or cleaning step. More specifically, the alcohol type liquid covers the solder ball and electrode surfaces to not only prevent reoxidation but also remove the initial surface oxide films from the solder ball surfaces, and hence enables the solder to be readily wetly spread over the electrode surfaces. It also makes greater the self-alignment effect attributable to the surface tension of the solder.

The above applying and bonding process in the present invention can be used not only in soldering but also any process of applying gold bumps or bonding with gold bumps which are widely used in BGA (ball grid array) and so forth. Use of the liquid as described above enables achievement of better bonding because of the -OH group reducing action to remove organic contaminant films from gold surfaces. The same applies also to bumps other than the gold bumps.

The respective liquids have different vaporization rates depending on surrounding conditions as exemplified by surrounding gases, heating device structure and surrounding pressure. The results shown this time are obtained when, e.g., Sn3 wt.% Ag solder (melting point: 221°C) is used and the heating is carried out, e.g., in an atmosphere of N2 or in an atmosphere of He. Differences in such surrounding conditions are considered to result in differences in the quantity of liquid remaining after heat reflowing. Basically, the wettability and self-alignment of solder can be ensured when the alcohol type liquid as shown in the drawing is applied in a quantity necessary only for covering the solder ball surfaces and electrode surfaces at least during the heat-melting. Also, after the bonding, the alcohol type liquid used may remain in the state it returned to room temperature. Such a liquid, however, has a high possibility of causing migration between electrodes, caused by the components composing the solder. Accordingly, it is preferable to remove the liquid by making cooling time longer, making surrounding gas flow rate higher or making surrounding pressure lower to accelerate the vaporization rate. For example, the liquid can be completely removed by making the surrounding pressure lower than 1 atmospheric pressure in the cooling step after the solder has solidified.

As for the processing atmosphere in which the above alcohol type liquid is used, it must be an inert atmosphere or an atmosphere having a low oxidizing action. It may preferably be an atmosphere having an oxygen concentration of 10 ppm or below.

POSSIBILITY OF INDUSTRIAL UTILIZATION

As described above in detail, the present invention can attain a process for manufacturing an electronic circuit device by which the solder can be applied without using any flux, which requires the cleaning step in order to remove its residues or because of its adhesion to assembling jigs. It can also attain a process for manufacturing an electronic circuit device by which electronic parts having solder balls can be bonded to circuit boards without using any flux, which requires the cleaning step in order to remove its residues or because of its adhesion to assembling jigs. Also, when the liquid having a reducing action is used as the liquid capable of vaporizing in the heat-melting step, the solder can be applied in a quantity necessary for soldering, without requiring any step of removing surface oxide films. Hence, a process for manufacturing an electronic circuit device can be attained which has enabled fluxless soldering that promises superior operability and mass productivity and a low cost.

Needless to say, the manner of applying solder balls is not limited to that in the Examples so long as the fluxless bonding is carried out using the above liquid. In other words, the fluxless bonding making use of the liquid of the present invention can be used in all objects to be bonded with solder.

**Claims**

1. A process for manufacturing an electronic circuit device by applying a solder material to an electrode the electronic circuit device has; said process comprising the steps of;

    removing an initial surface oxide film and/or an organic contaminant film from the surface(s) of the solder material and/or electrode;
    covering the solder material and/or the electrode with a liquid; and
    heat-melting the solder material;

    to carry out solder bonding without using any flux.

2. The process for manufacturing an electronic circuit device according to claim 1, wherein said liquid is a liquid capable of vaporizing up after the bonding is completed in the heat-melting step.

3. The process for manufacturing an electronic circuit device according to claim 1, wherein said liquid is a liquid having a reducing action.

4. The process for manufacturing an electronic circuit device according to claim 1, wherein said liquid is a liquid capable of provisionally fastening the solder material to the electrode.

5. The process for manufacturing an electronic circuit device according to claim 1, wherein a resist is formed in a thickness which is large at the area surrounding the electrode.

6. A process for manufacturing an electronic circuit device by applying a solder material to an electrode the electronic circuit device has; said process comprising the steps of;

printing or coating on the electrode a paste comprising a mixture of a liquid and a solder powder; said liquid having a reducing action to remove a surface oxide film and/or an organic contaminant film from the surface(s) of the solder material and/or electrode; and
heat-melting the paste;

to carry out solder bonding without using any flux.

7. A process for manufacturing an electronic circuit device, comprising the steps of,

mounting a solder material on an electrode with registration; said solder material being a material on which an initial surface oxide film has been thinly formed, and said electrode being an electrode on which an oxidation preventive film has been formed;
covering the solder material and/or the electrode with a liquid; and
heat-melting the solder material;

to carry out solder bonding without using any flux.

8. A process for manufacturing an electronic circuit device, comprising the steps of;

mounting an anisotropic conductive film on an electrode with registration; said film being a film on which solder has been formed correspondingly to an electrode to which the solder is to be applied, and said electrode being coated with a liquid; and
heat-melting the solder material.

9. A process for manufacturing an electronic circuit device by bonding an electronic part having solder balls to a circuit board; said process comprising the steps of;

removing an initial surface oxide film and/or an organic contaminant film from the solder material and/or the circuit board at its area to which solder is to be applied;
covering with a liquid the solder material and/or the circuit board at its area to which solder is to be applied; and
heat-melting the solder material;

to carry out solder bonding without using any flux.

10. The process for manufacturing an electronic circuit device according to claim 9, wherein said liquid is a liquid capable of vaporizing up after the bonding is completed in the heat-melting step.

11. The process for manufacturing an electronic circuit device according to claim 9, wherein said liquid is a liquid having a reducing action.

12. The process for manufacturing an electronic circuit device according to claim 9, wherein said liquid is a liquid capable of provisionally fastening the solder material to the electrode.

13. A process for manufacturing an electronic circuit device, comprising the steps of;

mounting a solder material with registration, on a circuit board at its area to which solder is to be applied; said solder material being a material an electronic part has and on which an initial surface oxide film has been thinly formed, and said area to which solder is to be applied being an area on the surface of which an oxidation preventive film has been formed;
covering with a liquid the solder material and/or the area to which solder is to be applied; and
heat-melting the solder material;

to carry out solder bonding without using any flux.

FIG. 1

(a)

(b)

(c)

(d)

(e)

FIG. 2

(a)

(b)

(c)

(d)

(e)

FIG. 3

(a)

(b)

(c)

(d)

(e)

EP 0 884 936 A1

FIG. 4

（a）

（b）

（c）

14

FIG. 5

( a )

( b )

( c )

FIG. 6

（a）

（b）

（c）

FIG. 7

(a)

(b)

(c)

FIG. 8

(a)

(b)

(c)

FIG. 9

(a)

(b)

(c)

O Good  △ Slightly poor  × Poor

| Liquid | | | | Liquid remaining after reflowing | Bonding evaluation | | Residue |
|--------|--|--|--|-----------------------------------|--------------------|--|---------|
| Type | Liquid name | Chemical formula | Boiling point | | Wettability | Self-alignment | |
| Alcohols | 2-Phenoxyethyl alcohol | $C_6H_5OCH_2CH_2OH$ | 510K | Present | O | O | O |
| | Triethylene glycol | $H(OCH_2CH_2)_3OH$ | 558K | Present | O | O | O |
| | Pentaethylene glycol | $H(OCH_2CH_2)_5OH$ | 643K | Present | O | O | O |
| | Hexaethylene glycol | $H(OCH_2CH_2)_6OH$ | 673K | Present | O | O | O |
| Hydrocarbons | 1-Tridecane | $CH_3(CH_2)_{11}CH_3$ | 507K | None | O | × | O |
| | 1-Hexadecane | $CH_3(CH_2)_{14}CH_3$ | 560K | Present | △ | × | × |
| Esters | Ethyl salicylate | $HOC_6H_4COOC_2H_5$ | 507K | Present | O | △ | O |
| Ketones | 2-Undecane | $CH_3(CH_2)_8COCH_3$ | 504K | Present | × | × | × |
| Aldehyde | Cinnamaldehyde | $C_6H_5CHCHCHO$ | 523K | Present | △ | × | × |
| Ethers | Methyl benzyl ether | $C_6H_5CH_2OCH_3$ | 559K | None | × | × | × |

FIG. 10

EP 0 884 936 A1

(a) REMOVAL OF OXIDES/CONTAMINANTS

LSI
SOLDER
EXCIMER LASER BEAMS
METALLIZED

LIQUID ALCOHOL

(b) ALIGNED WITH
THE ELECTRODES
(IN THE ATMOSPHERE)

(c) HEAT-MELTING
(NON-OXIDIZING ATMOSPHERE)
OXYGEN
CONCENTRATION < 1,000 ppm

FIG. 11

EP 0 884 936 A1

21

## FIG. 12

ANALYTICAL RESULTS (FT-IR)
OF RESIDUES

(a)

FLUX

FLUX RESIDUE

ROSIN
(ABIETIC ACID):

BENZENE RING

$-\overset{}{\underset{O}{C}}-OH$ : ORGANIC ACID

(b)

PENTAETHYLENE GLYCOL

RESIDUE ← PENTAETHYLENE GLYCOL

PENTAETHYLENE
GLYCOL:

H(OCH₂CH₂)₅OH

CH
(☆1)

$-\overset{}{\underset{O}{C}}-O-Me$
(ORGANIC ACID
METAL SALT)

C－O－C
(ETHER)
(☆2)

FIG. 13

| Evaluated liquid | | | Bonding evaluation | | |
|---|---|---|---|---|---|
| Type of liquid | Expected effect | | Wettability | Self-alignment | Residue |
| | Oxidation prevention | Reducing action | | | |
| Alcohols (-OH group) | Yes | Yes | ○ | ○ | ○ |
| Aldehydes (−CHO) | Yes | Yes | △ | × | × |
| Hydrocarbons | Yes | No | △ | × | × |
| Esters (R-COO-R²) | Yes | No | ○ | △ | ○ |
| Ketones (C=O) | Yes | No | × | × | × |

## INTERNATIONAL SEARCH REPORT

| International application No. |
|---|
| PCT/JP97/00614 |

| A. CLASSIFICATION OF SUBJECT MATTER |
|---|
| Int. Cl$^6$  H05K3/34, H01L21/60 |

According to International Patent Classification (IPC) or to both national classification and IPC

| B. FIELDS SEARCHED |
|---|
| Minimum documentation searched (classification system followed by classification symbols) |
| Int. Cl$^6$  H05K3/34, H01L21/60 |

Documentation searched other than minimum documentation to the extent that such documents are included in the fields searched

| | | |
|---|---|---|
| Jitsuyo Shinan Koho | 1926 – 1997 | Jitsuyo Shinan Toroku |
| Kokai Jitsuyo Shinan Koho | 1971 – 1997 | Koho     1996 – 1997 |
| Toroku Jitsuyo Shinan Koho | 1994 – 1997 | |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X | JP, 2-290693, A (Matsushita Electric Industrial Co., Ltd.), November 30, 1990 (30. 11. 90), Claim; page 2, lower left column, lines 7 to 13 (Family: none) | 6 |
| A | JP, 2-152246, A (Fujitsu Ltd.), June 12, 1990 (12. 06. 90)(Family: none) | 1 – 13 |
| A | JP, 4-220168, A (Union Carbide Industrial Gases Technology Corp.), August 11, 1992 (11. 08. 92) & EP, 447677, A & US, 5255840, A | 1 – 13 |
| A | JP, 6-291457, A (Seikosha Co., Ltd.), October 18, 1994 (18. 10. 94)(Family: none) | 1 – 13 |
| P | JP, 8-108292, A (Nippondenso Co., Ltd.), April 30, 1996 (30. 04. 96)(Family: none) | 1 – 13 |
| P | JP, 8-162753, A (Hitachi, Ltd.), | 1 – 13 |

☒ Further documents are listed in the continuation of Box C.    ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| May 22, 1997 (22. 05. 97) | June 3, 1997 (03. 06. 97) |

| Name and mailing address of the ISA/ | Authorized officer |
|---|---|
| Japanese Patent Office | |
| Facsimile No. | Telephone No. |

Form PCT/ISA/210 (second sheet) (July 1992)

**INTERNATIONAL SEARCH REPORT**

International application No.

PCT/JP97/00614

C (Continuation). DOCUMENTS CONSIDERED TO BE RELEVANT

| Category* | Citation of document, with indication, where appropriate, of the relevant passages | Relevant to claim No. |
|---|---|---|
| | June 21, 1996 (21. 06. 96)(Family: none) | |
| P | JP, 8-293665, A (Hitachi, Ltd.),<br>November 5, 1996 (05. 11. 96)(Family: none) | 1 - 13 |

Form PCT/ISA/210 (continuation of second sheet) (July 1992)